# EUROPÄISCHE PATENTANMELDUNG

(11) **EP 4 682 439 A1**
(43) Veröffentlichungstag der Anmeldung: **21.01.2026**
(21) Anmeldenummer: 24189407.0
(22) Anmeldetag: 18.07.2024
(51) Int. Cl.: F25B 1/10, F25B 9/00, F25B 40/02, F25B 49/02

(54) **PRÜFKAMMER UND VERFAHREN ZUR STEUERUNG**

(71) Anmelder: Weiss Technik GmbH, 35447 Reiskirchen (DE)
(72) Erfinder: Zahrt, Yannik, 35466 Rabenau (DE)
(74) Vertreter: advotec.

(57) **Zusammenfassung**

Die Erfindung betrifft ein Verfahren zur Konditionierung von Luft in einem gegenüber einer Umgebung verschließbaren und temperaturgedämmten Prüfraum einer Prüfkammer, sowie eine Prüfkammer, insbesondere Klimakammer, zur Aufnahme von Prüfgut, wobei mittels einer Kühleinrichtung (10) einer Temperiervorrichtung der Prüfkammer, mit einem Kühlkreislauf (11) mit Kohlenstoffdioxid als einem Kältemittel, einem Wärmeübertrager (12) in dem Prüfraum, einem Niederdruckverdichter (13) und einem in einer Strömungsrichtung des Kältemittels den Niederdruckverdichter nachfolgenden Hochdruckverdichter (14), einem Gaskühler (15) und einem Expansionsventil (16) eine Temperatur in einem Temperaturbereich von -40 °C bis +18 °C innerhalb des Prüfraums ausgebildet wird, wobei die Temperatur in dem Prüfraum mittels einer Steuervorrichtung der Prüfkammer gesteuert und/oder geregelt wird, wobei der Kühlkreislauf eine Ventileinrichtung (17) aufweist, mittels der Kältemittel zu dem Niederdruckverdichter oder zu dem Hochdruckverdichter geleitet wird.

## Beschreibung

Die Erfindung betrifft eine Prüfkammer, insbesondere Klimakammer zur Konditionierung von Luft, sowie ein Verfahren zur Konditionierung von Luft in einem gegenüber einer Umgebung verschließbaren und temperaturgedämmten Prüfraum einer Prüfkammer, insbesondere Klimakammer, zur Aufnahme von Prüfgut, wobei mittels einer Kühleinrichtung einer Temperiervorrichtung der Prüfkammer, mit einem Kühlkreislauf mit Kohlenstoffdioxid als einem Kältemittel, einem Wärmeübertrager in dem Prüfraum, einem Niederdruckverdichter und einem in einer Strömungsrichtung des Kältemittels dem Niederdruckverdichter nachfolgenden Hochdruckverdichter, einem Gaskühler und einem Expansionsventil eine Temperatur in einem Temperaturbereich von -40 °C bis +180 °C innerhalb des Prüfraums ausgebildet wird, wobei die Temperatur in dem Prüfraum mittels einer Steuervorrichtung der Prüfkammer gesteuert und/oder geregelt wird.

Derartige Prüfkammern werden regelmäßig zur Überprüfung von physikalischen und/oder chemischen Eigenschaften von Gegenständen, insbesondere Vorrichtungen eingesetzt. So sind Temperaturprüfschränke oder Klimaprüfschränke bekannt, innerhalb derer Temperaturen in einem Bereich von -70°C bis +180°C eingestellt werden können. Bei Klimaprüfschränken können ergänzend gewünschte Klimabedingungen eingestellt werden, denen dann die Vorrichtung bzw. das Prüfgut über einen definierten Zeitraum ausgesetzt wird. Eine Temperierung eines das zu prüfende Prüfgut aufnehmendem Prüfraums erfolgt regelmäßig in einem Umluftkanal innerhalb des Prüfraums. Der Umluftkanal bildet einen Luftbehandlungsraum im Prüfraum aus, in dem Wärmetauscher zur Erwärmung oder Kühlung der den Umluftkanal bzw. den Prüfraum durchströmenden Luft angeordnet sind. Dabei saugt ein Lüfter bzw. ein Ventilator die im Prüfraum befindliche Luft an und leitet sie im Umluftkanal zu den jeweiligen Wärmetauschern. Das Prüfgut kann so temperiert oder auch einem definierten Temperaturwechsel ausgesetzt werden. Während eines Prüfinterwalls kann dann beispielsweise eine Temperatur zwischen einem Temperaturmaximum und einem Temperaturminimum der Prüfkammer wechseln. Eine derartige Prüfkammer ist beispielweise aus der EP 0 344 397 A2 bekannt.

Das in einem Kühlkreislauf eingesetzte Kältemittel sollte ein relativ geringes CO₂+Äquivalent aufweisen, das heißt ein relatives Treibhauspotenzial oder auch Global Warming Potential (GWP) sollte möglichst gering sein, um eine indirekte Schädigung der Umwelt durch das Kältemittel bei Freisetzung zu vermeiden. Es ist daher auch bekannt Kohlenstoffdioxid (CO₂) bzw. Kohlendioxid als Reinstoffkältemittel zu verwenden. Kohlenstoffdioxid ist kostengünstig erhältlich, nicht brennbar und durch einen GWP von 1 im Wesentlichen umweltneutral. Kohlenstoffdioxid weist eine Gefriertemperatur bzw. einen Tripelpunkt von -56,6°C auf, was eine Erzielung von niedrigeren Temperaturen mit Kohlenstoffdioxid alleine nicht ermöglicht.

Da Kohlenstoffdioxid als Kältemittel eine sehr hohe volumetrische Kälteleistung aufweist, wird selbst bei einem Einsatz von Verdichtern mit sehr wenig Hubvolumenstrom eine sehr große Kälteleistung durch den Kühlkreislauf bereitgestellt. Darüber hinaus ist ein Druckbereich von Kühlkreisläufen mit Kohlenstoffdioxid als Kältemittel bei einem transkritischen Betrieb sehr hoch (bis 120 bar), weshalb die zur Ausbildung des Kühlkreislaufs erforderlichen Komponenten vergleichsweise teuer sind.

Weiter sind Kühleinrichtungen bekannt, die als sogenannte Boosteranlage ausgeführt sind. In einem Kühlkreislauf der Kühleinrichtungen ist stets ein Hochdruckverdichter einem Niederdruckverdichter in Reihe nachgeschaltet, so dass eine stufenweise Verdichtung des Kältemittels mit dem Niederdruckverdichter und nachfolgend mit dem Hochdruckverdichter erfolgt. Aufgrund der hohen Anforderungen an eine Temperaturregelung innerhalb des Temperaturbereichs des Prüfraums kommt es während eines Betriebs der Prüfkammer regelmäßig zu Schwankungen in einer Lastanforderung. Eine von den Verdichtern und dem Expansionsventil erzeugte Kälteleistung muss daher stufenlos regelbar sein. Gleichwohl ist es wünschenswert, dass die Verdichter, wenn es sich beispielsweise um Kompressoren handelt, nicht häufig eingeschaltet und ausgeschaltet werden, um eine Lebensdauer der Verdichter zu verlängern.

Um während eines Betriebs infolge eines Temperaturwechsels im Prüfraum auftretenden Lastschwankungen begegnen zu können, ist es auch bekannt, Kühleinrichtungen mit zwei Kreisläufen zu betreiben. Jedem Kühlkreislauf ist dann ein Expansionsventil zugeordnet und in den jeweiligen Kühlkreisläufen werden unterschiedliche Kältemittel eingesetzt, beispielsweise um unterschiedliche Temperaturbereiche abdecken zu können. Der dann innerhalb des Prüfraums verwendete Wärmeübertrager wird von den zwei Kühlkreisläufen durchströmt, was jedoch dazu führt, dass für die jeweiligen Kühlkreisläufe ein Teil einer Fläche des Wärmeübertragers zur Verfügung steht. Daher müssen am Wärmeübertrager größere Temperaturdifferenzen ausgebildet werden, was jedoch auch eine höhere Leistung der Kühleinrichtung bzw. der jeweiligen Verdichter erfordert. Bei einer Verwendung von Kohlstoffdioxid als Kältemittel ist es dann nachteilig, dass eine Verdampfungstemperatur nicht unter -56,6 °C abgesenkt werden kann.

Der vorliegenden Erfindung liegt daher die Aufgabe zugrunde, ein Verfahren zur Konditionierung von Luft in einem Prüfraum einer Prüfkammer sowie eine Prüfkammer vorzuschlagen, das bzw. die einen energieeffizienten Betrieb ermöglicht.

Diese Aufgabe wird durch ein Verfahren mit den Merkmalen des Anspruchs 1 und eine Prüfkammer mit den Merkmalen des Anspruchs 12 gelöst.

Bei dem erfindungsgemäßen Verfahren zur Konditionierung von Luft in einem gegenüber einer Umgebung verschließbaren und temperaturgedämmten Prüfraum einer Prüfkammer, insbesondere Klimakammer, zur Aufnahme von Prüfgut, wird mittels einer Kühleinrichtung einer Temperiervorrichtung der Prüfkammer, mit einem Kühlkreislauf mit Kohlenstoffdioxid als einem Kältemittel, einem Wärmeübertrager in dem Prüfraum, einem Niederdruckverdichter und einem in einer Strömungsrichtung des Kältemittels dem Niederdruckverdichter nachfolgenden Hochdruckverdichter, einem Gaskühler und einem Expansionsventil eine Temperatur in einem Temperaturbereich von -40 °C bis +180 °C innerhalb des Prüfraums ausgebildet, wobei die Temperatur in dem Prüfraum mittels einer Steuervorrichtung der Prüfkammer gesteuert und/oder geregelt wird, wobei der Kühlkreislauf eine Ventileinrichtung aufweist, mittels der Kältemittel zu dem Niederdruckverdichter oder zu dem Hochdruckverdichter geleitet wird.

Da der Hochdruckverdichter in Strömungsrichtung des Kältemittels nachfolgend dem Niederdruckverdichter angeordnet ist, kann das Kältemittel mittels der Ventileinrichtung wahlweise dem Niederdruckverdichter und nachfolgend dem Hochdruckverdichter oder alleine dem Hochdruckverdichter zugeführt werden. Da alleine zumindest ein Wärmeübertrager in dem Prüfraum angeordnet ist, welcher von dem Kältemittel des Kühlkreislaufs durchströmt wird, wird es möglich die gesamte Fläche des Wärmeübertragers mit dem Kühlkreislauf zur Temperierung des Prüf raums zu nutzen. Je nach Lastanforderung kann dann der Niederdruckverdichter zusammen mit dem Hochdruckverdichter oder alleine nur der Hochdruckverdichter betrieben werden. Da der gesamte Wärmeübertrager bzw. dessen gesamte wirksame Fläche, unabhängig von einem Betrieb der Verdichter, zur Temperierung des Prüfraums nutzbar ist, ist gegenüber einem nur zum Teil genutzten Wärmeübertrager eine vergleichsweise geringe Temperaturdifferenz zwischen dem Wärmeübertrager und einer Prüfraumatmosphäre erforderlich. Eine Verdichterleistung kann dann auch geringer sein und die Prüfkammer kann mit Kohlenstoffdioxid als Kältemittel mit dynamischeren Temperaturwechseln betrieben werden. Je nach Temperaturanforderung im Prüfraum kann die Steuervorrichtung die Ventileinrichtung steuern bzw. regeln. Wenn beispielsweise eine Temperatur von -20 °C am Wärmeübertrager ausgebildet werden soll, wird über die Ventileinrichtung alleine dem Hochdruckverdichter Kältemittel zugeführt. Wenn eine Temperatur von zum Beispiel -50 °C am Wärmeübertrager ausgebildet werden soll, wird das Kältemittel über die Ventileinrichtung dem Niederdruckverdichter und nachfolgend dem Hochdruckverdichter zugeführt. Im laufenden Betrieb der Prüfkammer kann der Niederdruckverdichter daher zeitweise abgeschaltet werden wodurch ein Großteil der für den Betrieb der Verdichter sonst erforderlichen Energie eingespart werden kann.

Die Ventileinrichtung kann in einer Strömungsrichtung des Kältemittels nachfolgend dem Wärmeübertrager im Kühlkreislauf angeordnet sein, wobei mittel der Ventileinrichtung Kältemittel zu dem Niederdruckverdichter oder unter Umgehung des Niederdruckverdichters zu dem Hochdruckverdichter geleitet werden kann. Die Ventileinrichtung kann durch ein oder mehrere Ventile, beispielsweise Magnetventile, ausgebildet sein. Wesentlich ist, dass die Ventileinrichtung Kältemittel in Abhängigkeit einer Temperaturanforderung der Steuervorrichtung unmittelbar zu dem Niederdruckverdichter oder an dem Niederdruckverdichter vorbei unmittelbar zu dem Hochdruckverdichter leiten kann. Wenn Kältemittel unter Umgehung des Niederdruckverdichters an den Hochdruckverdichter geleitet wird, kann der Niederdruckverdichter abgeschaltet werden.

Der Kühlkreislauf kann einen Verdichterbypass aufweisen, der in einer Strömungsrichtung des Kältemittels nachfolgend dem Wärmeübertrager und vor dem Niederdruckverdichter sowie nachfolgend dem Niederdruckverdichter und vor dem Hochdruckverdichter an eine Zwischendruckseite des Kühlkreislaufs angeschlossen sein kann, wobei mittels der Ventileinrichtung Kältemittel zu dem Niederdruckverdichter oder über den Verdichterbypass zu dem Hochdruckverdichter geleitet werden kann. Der Verdichterbypass kann durch einen Leitungsabschnitt des Kühlkreislaufs ausgebildet sein, der den Niederdruckverdichter überbrückt.

Die Steuervorrichtung kann in Abhängigkeit einer Soll-Temperatur den Hochdruckverdichter betreiben und den Niederdruckverdichter abschalten und die Ventileinrichtung derart betätigen, dass Kältemittel zu dem Hochdruckverdichter geleitet wird, oder den Hochdruckverdichter und den Niederdruckverdichter betreiben und die Ventileinrichtung derart betätigen, dass Kältemittel zu dem Niederdruckverdichter geleitet wird. Nachfolgend dem Niederdruckverdichter kann das Kältemittel dann zu dem Hochdruckverdichter geleitet werden. In allen Fällen kann der Kühlkreislauf transkritisch betrieben werden, ohne dass eine vollständige Verflüssigung des Kältemittels in dem Kühlkreislauf erfolgt.

Im Kühlkreislauf kann ein Niederdruckbypass mit zumindest einem Niederdruckventil ausgebildet sein, wobei der Niederdruckbypass in Strömungsrichtung nach dem Gaskühler und vor dem Expansionsventil an eine Mitteldruckseite des Kühlkreislaufs sowie nach der Ventileinrichtung und vor dem Niederdruckverdichter an eine Niederdruckseite des Kühlkreislaufs angeschlossen sein kann, wobei eine Sauggastemperatur und/oder ein Sauggasdruck des Kältemittels auf der Niederdruckseite des Kühlkreislaufs vor dem Niederdruckverdichter derart geregelt werden kann, dass über das Niederdruckventil Kältemittel in die Niederdruckseite dosiert werden kann. Optional kann vorgesehen sein, dass der Niederdruckbypass nach dem Gaskühler in Strömungsrichtung nachfolgend einem internen Wärmeübertrager in dem Kühlkreislauf an die Mitteldruckseite angeschlossen ist. Mittels des Niederdruckventils kann so die Sauggastemperatur und/oder der Sauggasdruck vor dem Niederdruckverdichter derart beeinflusst werden, dass sich eine Verdichtungsendtemperatur des Niederdruckverdichters innerhalb eines für den Niederdruckverdichter vorgesehenen Betriebsbereichs befindet. So kann eine Sauggastemperatur des Niederdruckverdichters besonders stark ansteigen, wenn eine Temperatur in dem Prüfraum von beispielsweise +180 °C auf eine niedrigere Temperatur abgesenkt werden soll. Da sich der Wärmeübertrager im Prüfraum befindet, kann bei besonders hohen Temperaturen im Prüfraum von beispielsweise +180 °C das Kältemittel mit dieser Temperatur aus dem Wärmeübertrager zu dem Niederdruckverdichter strömen. Bevor das stark überhitzte Kältemittel dem Niederdruckverdichter zugeführt wird, kann es durch das über das Niederdruckventil expandierte Kältemittel abgekühlt werden. Der Niederdruckbypass ist auch dann nutzbar, wenn ein ausreichend großer Massenstrom vor dem Niederdruckverdichter für einen Verdichterbetrieb ausgebildet werden muss.

In dem Kühlkreislauf kann ein Regelbypass mit zumindest einem Regelventil ausgebildet sein, wobei der Regelbypass in Strömungsrichtung nach dem Niederdruckverdichter und vor dem Hochdruckverdichter an eine Zwischendruckseite des Kühlkreislaufs sowie vor dem Niederdruckverdichter und nach der Ventileinrichtung an einer Niederdruckseite des Kühlkreislaufs angeschlossen sein kann, wobei über das Regelventil Kältemittel in die Niederdruckseite dosiert werden kann, wobei eine Sauggastemperatur und/oder ein Sauggasdruck des Kältemittels auf der Niederdruckseite des Kühlkreislaufs vor dem Niederdruckverdichter geregelt werden kann und/oder eine Druckdifferenz zwischen der Zwischendruckseite und der Niederdruckseite des Kühlkreislaufs ausgeglichen werden kann. Beispielsweise kann der Niederdruckverdichter zusammen mit dem Hochdruckverdichter in einem Temperaturbereich von ≤ -10 °C betrieben werden, wobei das Regelventil dann zunächst vollständig geschlossen werden kann. Das Regelventil kann zu einer Leistungsregelung des Niederdruckverdichters genutzt werden, indem kaltes, gasförmiges Kältemittel von der Zwischendruckseite zurück auf die Niederdruckseite geleitet wird. In diesem Fall kann auf eine Einspritzung von flüssigem Kältemittel in die Niederdruckseite, beispielsweise über einen Niederdruckbypass verzichtet werden. Weiter kann von der Steuervorrichtung mittels des Regelbypass ein Saugdruck vor dem Niederdruckverdichter eingestellt werden, derart, dass sich das Kältemittel vor dem Niederdruckverdichter in einen Zustand unterhalb des Tripelpunkts von Kohlenstoffdioxid befindet. Durch einen Verzicht einer Einspritzung von flüssigem Kältemittel in die Niederdruckseite und die Zuführung von kaltem, gasförmigem Kältemittel von der Zwischendruckseite kann ein Saugdruck vor dem Niederdruckverdichter unterhalb des Tripelpunkts abgesenkt werden ohne dass es hier zu einer Trockeneisbildung kommt. Dies ist besonders vorteilhaft bei langen Saugleitungen, um Druckverlust über die Saugleitung zu kompensieren und um sicherzustellen, dass bei tiefen Temperaturen im Prüfraum eine ausreichend hohe Differenz zwischen der Temperatur im Prüfraum und einer Temperatur an dem Wärmeübertrager bzw. eine Verdampfungstemperatur des Kältemittels vorhanden ist.

Der Kühlkreislauf kann einen Zwischendruckbypass aufweisen, der in der Strömungsrichtung nachfolgend dem Gaskühler und vor dem Expansionsventil an einer Mitteldruckseite des Kühlkreislaufs sowie vor dem Hochdruckverdichter und nachfolgend dem Niederdruckverdichter an einer Zwischendruckseite des Kühlkreislaufs angeschlossen sein kann, wobei mittels einen Zwischendruckventils Kältemittel von der Mitteldruckseite in die Zwischendruckseite dosiert werden kann. Mit dem Zwischendruckbypass kann dann eine so genannte Zwischendruckeinspritzung von Kältemittel in eine den Niederdruckverdichter mit dem Hochdruckverdichter verbindende Leitung bzw. Zwischendruckseite durchgeführt werden. Das über den Zwischendruckbypass geleitete Kältemittel kann dann an dieser Stelle dem in dem Kühlkreislauf zirkulierenden Kältemittel beigemischt werden. Durch das Beimischen des Kältemittels kann das sich in Strömungsrichtung vor dem Hochdruckverdichter befindliche Kältemittel temperiert werden. Optional kann vorgesehen sein, dass der Zwischendruckbypass nach dem Gaskühler in Strömungsrichtung nachfolgend einem internen Wärmeübertrager in dem Kühlkreislauf an die Mitteldruckseite angeschlossen ist. Mittels des Zwischendruckventils kann so die Sauggastemperatur und/oder der Sauggasdruck vor dem Hochdruckverdichter derart beeinflusst werden, dass sich eine Verdichtungsendtemperatur des Hochdruckverdichters innerhalb eines für den Hochdruckverdichter vorgesehenen Betriebsbereichs befindet. So kann eine Sauggastemperatur des Hochdruckverdichters besonders stark ansteigen, wenn eine Temperatur in dem Prüfraum von beispielsweise +180 °C auf eine niedrigere Temperatur abgesenkt werden soll. Da sich der Wärmeübertrager im Prüfraum befindet, kann bei besonders hohen Temperaturen im Prüfraum von beispielsweise +180 °C das Kältemittel mit dieser Temperatur aus dem Wärmeübertrager zu dem Hochdruckverdichter strömen. Bevor das stark überhitzte Kältemittel dem Hochdruckverdichter zugeführt wird, kann es durch das über das Zwischendruckventil expandierte Kältemittel abgekühlt werden. Der Zwischendruckbypass ist auch dann nutzbar, wenn ein ausreichend großer Massenstrom vor dem Hochdruckverdichter für einen Verdichterbetrieb ausgebildet werden muss.

Der Kühlkreislauf kann ein Hochdruckventil und eine Speichereinrichtung aufweisen, die an einer Hochdruckdruckseite des Kühlkreislaufs in der Strömungsrichtung nachfolgend dem Gaskühler und vor dem Expansionsventil angeschlossen sein können, wobei über das Hochdruckventil Kältemittel in die Speichereinrichtung dosiert werden kann. Mittels des Hochdruckventils kann eine erste Entspannung des Kältemittels erfolgen, welches dann unmittelbar nachfolgend dem Hochdruckventil in die Speichereinrichtung eingeleitet werden kann. Die Speichereinrichtung ist somit auf der Mitteldruckseite des Kühlkreislaufs nachfolgend dem Hochdruckventil verbaut. Innerhalb der Speichereinrichtung, welche durch einen Druckbehälter ausgebildet sein kann, kann dann eine Phasentrennung des Kältemittels dahingehend erfolgen, dass sich flüssiges Kältemittel in einem unteren Bereich der Speichereinrichtung und sich gasförmiges Kältemittel in einem oberen Bereich der Speichereinrichtung ansammelt. Das flüssige und das gasförmige Kältemittel kann dann je nach Temperaturanforderung zum Betrieb des Kühlkreislaufs verwendet werden. Das flüssige Kältemittel kann über das Expansionsventil zur Normalkühlung des Wärmeübertragers genutzt werden. Das gasförmige Kältemittel kann beispielsweise zu dem Hochdruckverdichter geleitet werden. Dies ist insbesondere dann vorteilhaft, wenn vor dem Hochdruckverdichter flüssiges Kältemittel ansteht, was es zu vermeiden gilt.

Der Kühlkreislauf kann einen internen Wärmeübertrager aufweisen, der an der Hochdruckseite des Kühlkreislaufs in der Strömungsrichtung nachfolgend dem Gaskühler und vor dem Expansionsventil angeschlossen sein kann, wobei der interne Wärmeübertrager mit einem Flashgas-Bypass des Kühlkreislaufs gekoppelt sein kann, wobei der Flashgas-Bypass in der Strömungsrichtung nachfolgend dem internen Wärmeübertrager und vor dem Expansionsventil an der Speichereinrichtung sowie vor dem Hochdruckverdichter und nachfolgend dem Niederdruckverdichter an eine Zwischendruckseite des Kühlkreislaufs angeschlossen sein kann, wobei mittels eines Flashgasventils des Flashgas-Bypasses gasförmiges Kältemittel von der Speichereinrichtung über den internen Wärmeübertrager in die Zwischendruckseite dosiert werden kann. Der Flashgas-Bypass wird folglich in einem oberen Bereich der Speichereinrichtung an diese so angeschlossen, dass gasförmiges Kältemittel der Speichereinrichtung entnommen werden kann. Das Flashgasventil kann dann zum Ausleiten und Dosieren von gasförmigem Kältemittel aus der Speichereinrichtung dienen. Mittels des internen Wärmeübertragers kann transkritisches Kältemittel, welches von dem Gaskühler zu dem Hochdruckventil strömt, unterkühlt werden. Gleichzeitig kann mit dem internen Wärmeübertrager gasförmiges Kältemittel in dem Flashags-Bypass überhitzt und zu dem Hochdruckverdichter geleitet werden. Dies ist besonders vorteilhaft, da in Strömungsrichtung vor dem Hochdruckverdichter kein flüssiges Kältemittel anstehen sollte. Mit dem überhitzten Kältemittel aus dem Flashgas-Bypass kann so sichergestellt werden, dass vom Hochdruckverdichter ausschließlich gasförmiges Kältemittel angesaugt wird.

In dem Kühlkreislauf kann ein weiterer Bypass mit zumindest einem weiteren Ventil ausgebildet sein, wobei der weitere Bypass in Strömungsrichtung nach dem Gaskühler und vor dem Expansionsventil an einer Mitteldruckseite des Kühlkreislaufs sowie nach dem Wärmeübertrager und vor der Ventileinrichtung an einer Niederdruckseite des Kühlkreislaufs angeschlossen sein kann, wobei eine Sauggastemperatur und/oder ein Sauggasdruck des Kältemittels auf der Niederdruckseite des Kühlkreislaufs vor der Ventileinrichtung derart geregelt werden kann, dass über das weitere Ventil Kältemittel in die Niederdruckseite dosiert werden kann. Mit dem weiteren Bypass kann insbesondere eine Kühlung der Ventileinrichtung erfolgen, wenn in diesem Bereich eine Temperatur für die Ventileinrichtung zu hoch ist. Über den weiteren Bypass kann auch Kältemittel in Strömungsrichtung vor den Niederdruckverdichter geleitet werden, um einen erforderlichen Massenstrom vor dem Niederdruckverdichter bereitzustellen. Mittels des weiteren Ventils kann auch eine Sauggastemperatur und/oder der Sauggasdruck vor dem Niederdruckverdichter, und je nach Betätigung der Ventileinrichtung vor dem Hochdruckverdichter derart beeinflusst werden, dass sich eine Verdichtungsendtemperatur des Niederdruckverdichters bzw. Hochdruckverdichters innerhalb eines für den Niederdruckverdichter bzw. Hochdruckverdichter vorgesehenen Betriebsbereichs befindet.

Vorteilhaft kann reines Kohlenstoffdioxid als das Kältemittel verwendet werden. Reines Kohlenstoffdioxid weist einen GWP von 1 auf, ist nicht brennbar, ungefährlich und kostengünstig erhältlich. Darüber hinaus ist Kohlenstoffdioxid ein Reinstoff bzw. azeotrop, was die vorteilhafte Durchführung des Verfahrens und dessen Varianten überhaupt erst ermöglicht. Ein Kältemittel mit zeotropen Verhalten würde hingegen eine Bereitstellung einer ausreichenden Menge von gasförmigem Kältemittel bei einer sehr geringen Temperaturdifferenz kaum ermöglich und somit eine Leistungsregelung der jeweiligen Verdichter kaum zulassen.

Mittels der Temperiervorrichtung kann eine Temperatur in einen Temperaturbereich von -50 °C bis +180 °C, bevorzugt von -55 °C bis +180 °C, innerhalb des Prüfraums ausgebildet werden.

Eine Drehzahl des Hochdruckverdichters und/oder des Niederdruckverdichters kann geregelt werden. Der Hochdruckverdichter und/oder der Niederdruckverdichter kann jeweils mit einem Frequenzumrichter ausgebildet sein, welcher eine Drehzahlregelung der Verdichter erlaubt. Durch eine Absenkung der Drehzahl kann ein Massenstrom des Kältemittels in einem Teillast-Betriebszustand des Kühlkreislaufs weiter verringert und so eine Effizienz der Kühleinrichtung in diesem Betriebszustand weiter gesteigert werden. Weiter ermöglicht eine Drehzahlregelung des Niederdruckverdichters ein Anheben und Absenken der Drehzahl des Niederdruckverdichters durch die Steuervorrichtung derart, dass ein Sauggasdruck auf einer Niederdruckseite des Kühlkreislaufs veränderbar ist und so in einer gewünschten Weise angepasst werden kann.

Die erfindungsgemäße Prüfkammer, insbesondere Klimakammer, zur Konditionierung von Luft, umfasst einen gegenüber einer Umgebung verschließbaren und temperaturgedämmten Prüfraum zur Aufnahme von Prüfgut, und eine Temperiervorrichtung zur Temperierung des Prüfraums, wobei mittels der Temperiervorrichtung eine Temperatur in einem Temperaturbereich von -40 °C bis +180 °C innerhalb des Prüfraums ausbildbar ist, wobei die Temperiervorrichtung eine Kühleinrichtung mit einem Kühlkreislauf mit Kohlenstoffdioxid als einem Kältemittel, einem Wärmeübertrager in dem Prüfraum, einem Niederdruckverdichter und einem in einer Strömungsrichtung des Kältemittels dem Niederdruckverdichter nachfolgenden Hochdruckverdichter, einem Gaskühler und einem Expansionsventil aufweist, wobei die Prüfkammer eine Steuervorrichtung zur Steuerung und/oder Regelung der Temperatur in dem Prüfraum aufweist, wobei der Kühlkreislauf eine Ventileinrichtung aufweist, mittels der Kältemittel zu dem Niederdruckverdichter oder zu dem Hochdruckverdichter leitbar ist. Zu den Vorteilen der erfindungsgemäßen Prüfkammer wird auf die Vorteilsbeschreibung des erfindungsgemäßen Verfahrens verwiesen.

Die Ventileinrichtung kann durch ein 3-Wege-Ventil ausgebildet sein. Prinzipiell ist es möglich, die Ventileinrichtung durch eine Mehrzahl von Ventilen auszubilden die ihrerseits von der Steuervorrichtung so betätigt werden, dass Kältemittel zu dem Niederdruckverdichter oder dem Hochdruckverdichter geleitet wird. Das 3-Wege-Ventil ermöglicht jedoch eine besonders einfache Ausbildung der Ventileinrichtung und ein wahlweises Zuführen von Kältemittel zu dem Niederdruckverdichter oder dem Hochdruckverdichter. Das 3-Wege-Ventil kann nachfolgend dem Wärmeübertrager und vor dem Niederdruckverdichter bzw. über einen Verdichterbypass vor dem Hochdruckverdichter und nachfolgend dem Niederdruckverdichter an den Kühlkreislauf anschlossen sein. Das 3-Wege-Ventil kann mittels der Steuervorrichtung einfach betätigt werden.

Der Wärmeübertrager kann mit alleine einem Übertragerkörper ausgebildet sein, wobei alleine eine Leitung des Kühlkreislaufs durch den Übertragerkörper verlaufen kann. Somit ist es dann auch möglich eine für eine Temperierung wirksame Fläche des Übertragerkörpers vollständig mit der Leitung des Kühlkreislaufs zu nutzen, sodass auch mit einer vergleichsweise geringen Temperaturdifferenz von Übertragerkörper und Temperatur im Prüfraum ein dynamischer Wechsel der Temperatur im Prüfraum erfolgen kann. Wesentlich ist, dass der Übertragerkörper unmittelbar nachfolgend dem Expansionsventil an den Kühlkreislauf angeschlossen ist, derart, dass alleine über das Expansionsventil strömendes Kältemittel durch den Übertragerkörper geleitet wird. Unter einem Übertragerkörper wird hier ein Korpus verstanden, der beispielsweise einteilig oder mehrteilig ausgebildet sein kann und der von dem Kältemittel durchströmt wird. Hierunter fallen auch Leitungsanordnungen die mit Lamellen zu besseren Wärmeübertragung versehen sind. Die Lamellen bilden dann zusammen mit der bzw. den Leitungsanordnungen den Übertragerkörper aus. Der Übertragerkörper weist dann eine zur Wärmeübertragung wirksame Fläche auf.

Die Temperiervorrichtung kann eine Heizeinrichtung mit einer Heizung und einem Heiz-Wärmeübertrager in dem Prüfraum aufweisen. Die Heizeinrichtung kann beispielsweise eine elektrische Widerstandsheizung sein, die den Heiz-Wärmeübertrager beheizt, derart, dass über den Heiz-Wärmeübertrager eine Temperaturerhöhung im Prüfraum ermöglicht wird. Wenn der Wärmeübertrager und der Heiz-Wärmeübertrager mittels der Steuervorrichtung zur Kühlung oder Erwärmung der im Prüfraum umgewälzten Luft gezielt gesteuert bzw. geregelt werden können, kann mittels der Temperiervorrichtung dann innerhalb des Prüfraums eine Temperatur in dem vorstehend angegebenen Temperaturbereich ausgebildet werden.

Weitere Ausführungsformen einer Prüfkammer ergeben sich aus den Merkmalsbeschreibungen der auf den Verfahrensanspruch 1 rückbezogenen Unteransprüche.

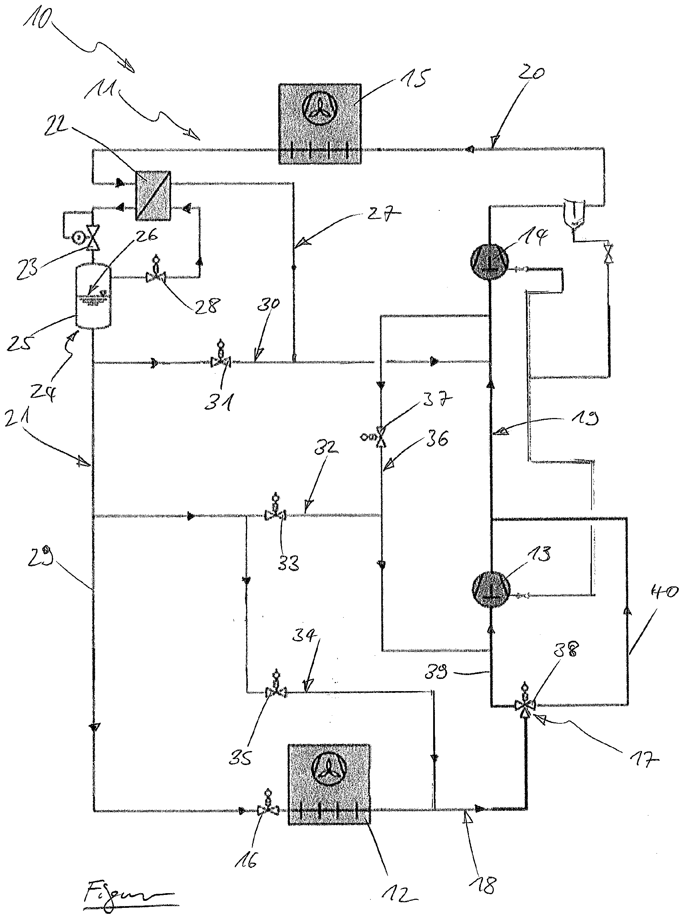

Nachfolgend wird eine bevorzugte Ausführungsform der Erfindung unter Bezugnahme auf die beigefügte Zeichnung näher erläutert.

Die Figur zeigt eine mögliche Ausführungsform einer Kühleinrichtung 10 einer hier nicht dargestellten Prüfkammer. Die Kühleinrichtung 10 umfasst einen Kühlkreislauf 11 mit Kohlenstoffdioxid (CO₂) als einem Kältemittel, einen Wärmeübertrager 12, einen Niederdruckverdichter 13, einen Hochdruckverdichter 14, einen Gaskühler 15, ein Expansionsventil 16 und eine Ventileinrichtung 17. Der Gaskühler 15 ist hier in Art eines Wärmeübertragers ausgebildet und über ein Wärmeträgermedium, wie beispielsweise Luft oder Wasser, gekühlt. Der Wärmeübertrager 12 ist in einem hier nicht dargestellten Luftbehandlungskanal der Prüfkammer angeordnet, derart, dass ein hier nicht dargestellter Lüfter die Luft im Prüfraum an dem Wärmeübertrager 12 umwälzen kann. Weiter weist der Kühlkreislauf 11 eine Niederdruckseite 18, eine Zwischendruckseite 19, eine Hochdruckseite 20 und eine Mitteldruckseite 21 auf. In der Niederdruckseite 18 ist ein Druck des Kältemittels vergleichsweise niedriger als in der Zwischendruckseite 19. In der Zwischendruckseite 19 ist ein Druck des Kältemittels vergleichsweise niedriger als in der Mitteldruckseite 21 und in der Mitteldruckseite 21 ist ein Druck des Kältemittels vergleichsweise niedriger als in der Hochdruckseite 20.

Der Kühlkreislauf 11 weist weiterhin in einer Strömungsrichtung des Kältemittels nachfolgend dem Gaskühler 15 einen internen Wärmeübertrager 22 und ein Hochdruckventil 23 auf, über das gasförmiges Kältemittel in eine Speichereinrichtung 24 entspannt bzw. dosiert wird. Die Speichereinrichtung 24 ist als ein Druckbehälter 25 ausgebildet, in dem sich eine Phasengrenze 26 zwischen dem flüssigen und dem gasförmigen Kältemittel ausbildet. An der Speichereinrichtung 24 ist ein Flashgas-Bypass 27 mit einem Flashgas-Ventil 28 des Kühlkreislaufs 11 so angeschlossen, dass aus der Speichereinrichtung 24 gasförmiges Kältemittel entnommen und auf die Zwischendruckseite 19 in Strömungsrichtung des Kältemittels nachfolgend dem Niederdruckverdichter 13 und vor dem Hochdruckverdichter 14 geleitet werden kann. Weiter ist an der Speichereinrichtung 24 ein Leitungsabschnitt 29 so angeschlossen, dass aus der Speichereinrichtung 24 flüssiges Kältemittel entnommen und zu dem Expansionsventil 16 geleitet werden kann.

Mit dem internen Wärmeübertrager 22 kann von dem Gaskühler 15 zu dem Hochdruckventil 23 strömendes Kältemittel unterkühlt werden, wobei das über das Flashgas-Ventil 28 in die Zwischendruckseite 19 vor dem Hochdruckverdichter 14 strömendes Kältemittel in dem internen Wärmeübertrager 22 überhitzt werden kann. Hierdurch kann sichergestellt werden, dass sich vor dem Hochdruckverdichter 14 gasförmiges Kältemittel befindet, sodass der Hochdruckverdichter 14 nur dieses ansaugen kann.

Darüber hinaus umfasst der Kühlkreislauf 11 einen Zwischendruckbypass 30 mit einem Zwischendruckventil 31, wobei der Zwischendruckbypass 30 in einer Strömungsrichtung nachfolgend der Speichereinrichtung 24 an den Leitungsabschnitt 29 sowie nachfolgend dem Niederdruckverdichter 13 und vor dem Hochdruckverdichter 14 an den Kühlkreislauf 11 bzw. die Zwischendruckseite 19 angeschlossen ist. Mittels des Zwischendruckventils 31 kann flüssiges Kältemittel aus der Speichereinrichtung 24 in die Zwischendruckseite 19 dosiert werden, beispielsweise wenn eine Temperatur des Kältemittels vor dem Hochdruckverdichter 14 abgesenkt werden soll. Weiter umfasst der Kühlkreislauf 11 einen Niederdruckbypass 32 mit einem Niederdruckventil 33, wobei der Niederdruckbypass 32 in einer Strömungsrichtung nachfolgend der Speichereinrichtung 24 am Leitungsabschnitt 29 sowie nachfolgend der Ventileinrichtung 17 an der Niederdruckseite 18 unmittelbar vor dem Niederdruckverdichter 13 angeschlossen ist. Mittels des Niederdruckventils 33 kann flüssiges Kältemittel aus der Speichereinrichtung 24 in die Niederdruckseite 18 vor den Niederdruckverdichter 13 dosiert werden, beispielsweise, wenn von dem Niederdruckverdichter 13 angesaugtes Kältemittel gekühlt werden soll.

Der Kühlkreislauf 11 weist einen weiteren Bypass 34 mit einem weiteren Ventil 35 auf. Der weitere Bypass 34 ist nachfolgend der Speichereinrichtung 24 an den Leitungsabschnitt 29 nachfolgend dem Wärmeübertrager 12 und in Strömungsrichtung vor der Ventileinrichtung 17 an der Niederdruckseite 18 des Kühlkreislaufs 11 angeschlossen. Mittels des weiteren Ventils 35 kann flüssiges Kältemittel aus der Speichereinrichtung 24 in die Niederdruckseite 18 in Strömungsrichtung vor die Ventileinrichtung 17 dosiert werden. Hierdurch ist es möglich die Ventileinrichtung 17 wenn nötig zu kühlen und einen ausreichenden Massenstrom für den Niederdruckverdichter 13 oder den Hochdruckverdichter 14 zur Verfügung zu stellen.

Der Kühlkreislauf 11 weist weiter einen Regelbypass 36 mit einem Regelventil 37 auf. Der Regelbypass 36 ist in Strömungsrichtung nach dem Niederdruckverdichter 13 und vor dem Hochdruckverdichter 14 an die Zwischendruckseite 19 sowie vor dem Niederdruckverdichter 13 und nach der Ventileinrichtung 17 an die Niederdruckseite 18 des Kühlkreislaufs 11 angeschlossen. Über das Regelventil 37 kann Kältemittel von der Zwischendruckseite 19 in die Niederdruckseite 18 dosiert werden. Hierdurch wird es möglich eine Sauggastemperatur bzw. einen Sauggasdruck des Kältemittels auf der Niederdruckseite 18 vor dem Niederdruckverdichter 13 zu regeln und bei Bedarf eine Druckdifferenz zwischen der Zwischendruckseite 19 und der Niederdruckseite 18 des Kühlkreislaufs 11 auszugleichen.

Die Ventileinrichtung 17 ist durch ein 3-Wege-Ventil 38 ausgebildet. Je nach Temperaturanforderung einer nicht dargestellten Steuervorrichtung der Prüfkammer wird das 3-Wege-Ventil 38 so von der Steuervorrichtung betätigt, dass das aus dem Wärmeübertrager 12 strömende Kältemittel über eine unmittelbar an dem 3-Wege-Ventil 38 angeschlossene Niederdruckleitung 39 unmittelbar zu dem Niederdruckverdichter 13 geleitet wird. Diese Kältemittel wird von dem Niederdruckverdichter 13 verdichtet und gelangt danach weiter zu dem Hochdruckverdichter 14 zur weiteren Verdichtung. Die Steuervorrichtung kann das 3-Wege-Ventil 38 auch so betätigen, dass das Kältemittel über einen Verdichterbypass 40, welcher unmittelbar an dem 3-Wege-Ventil 38 angeschlossen ist, unter Umgehung des Niederdruckverdichter 13 zu dem Hochdruckverdichter 14 gelangt. Der Verdichterbypass 40 ist in Strömungsrichtung nachfolgend dem Niederdruckverdichter 13 und vor dem Hochdruckverdichter 14 an die Zwischendruckseite 19 angeschlossen. Je nach Temperaturanforderung ist es so möglich den Niederdruckverdichter 13 zusammen mit dem Hochdruckverdichter 14 oder nur alleine den Hochdruckverdichter 14 zu betreiben. Dadurch, dass dann der Niederdruckverdichter 13 abgeschaltet ist, kann eine wesentliche Energieeinsparung erzielt werden. Der Hochdruckverdichter 14 wird insbesondere dann alleine betrieben, wenn beispielsweise eine Temperatur von -20 °C im Prüfraum ausgebildet werden soll. Der Niederdruckverdichter 13 und der Hochdruckverdichter 14 werden dann zusammen betrieben, wenn beispielsweise eine Temperatur von -50 °C in dem Prüfraum ausgebildet werden soll.

Der Wärmeübertrager 12 ist bevorzugt mit alleine einem hier nicht dargestellten Übertragerkörper ausgebildet, wobei alleine eine Leitung des Kühlkreislaufs 11 durch den Übertragerkörper verläuft. Eine Fläche des Übertragerkörpers ist so vollständig mit dem Kühlkreislauf 11 nutzbar, weshalb eine Temperaturdifferenz zwischen einer Atmosphäre des Prüfraums und des Wärmeübertragers 12, wenn eine Temperaturänderung in den Prüfraum ausgebildet werden soll, vergleichsweise niedrig sein kann. Weiter ist im Prüfraum eine hier nicht dargestellte Heizeinrichtung mit einer Heizung und einem Heiz-Wärmeübertrager vorgesehen.

### Bezugszeichenliste

- 10: Kühleinrichtung
- 11: Kühlkreislauf
- 12: Wärmeübertrager
- 13: Niederdruckverdichter
- 14: Hochdruckverdichter
- 15: Gaskühler
- 16: Expansionsventil
- 17: Ventileinrichtung
- 18: Niederdruckseite
- 19: Zwischendruckseite
- 20: Hochdruckseite
- 21: Mitteldruckseite
- 22: interner Wärmeübertrager
- 23: Hochdruckventil
- 24: Speichereinrichtung
- 25: Druckbehälter
- 26: Phasengrenze
- 27: Flashgas-Bypass
- 28: Flashgas-Ventil
- 29: Leitungsabschnitt
- 30: Zwischendruckbypass
- 31: Zwischendruckventil
- 32: Niederdruckbypass
- 33: Niederdruckventil
- 34: weiterer Bypass
- 35: weiteres Ventil
- 36: Regelbypass
- 37: Regelventil
- 38: 3-Wege-Ventil
- 39: Niederdruckleitung
- 40: Verdichterbypass

## Patentansprüche

1. Verfahren zur Konditionierung von Luft in einem gegenüber einer Umgebung verschließbaren und temperaturgedämmten Prüfraum einer Prüfkammer, insbesondere Klimakammer, zur Aufnahme von Prüfgut, wobei mittels einer Kühleinrichtung (10) einer Temperiervorrichtung der Prüfkammer, mit einem Kühlkreislauf (11) mit Kohlenstoffdioxid (CO₂) als einem Kältemittel, einem Wärmeübertrager (12) in dem Prüfraum, einem Niederdruckverdichter (13) und einem in einer Strömungsrichtung des Kältemittels dem Niederdruckverdichter nachfolgenden Hochdruckverdichter (14), einem Gaskühler (15) und einem Expansionsventil (16) eine Temperatur in einem Temperaturbereich von -40 °C bis +180 °C innerhalb des Prüfraums ausgebildet wird, wobei die Temperatur in dem Prüfraum mittels einer Steuervorrichtung der Prüfkammer gesteuert und/oder geregelt wird, **dadurch gekennzeichnet,**
**dass** der Kühlkreislauf eine Ventileinrichtung (17) aufweist, mittels der Kältemittel zu dem Niederdruckverdichter oder zu dem Hochdruckverdichter geleitet wird.

2. Verfahren nach Anspruch 1,
**dadurch gekennzeichnet,**
**dass** die Ventileinrichtung (17) in einer Strömungsrichtung des Kältemittels nachfolgend dem Wärmeübertrager (12) in dem Kühlkreislauf (11) angeordnet ist, wobei mittels der Ventileinrichtung Kältemittel zu dem Niederdruckverdichter (13) oder unter Umgehung des Niederdruckverdichters zu dem Hochdruckverdichter (14) geleitet wird.

3. Verfahren nach Anspruch 1 oder 2,
**dadurch gekennzeichnet,**
**dass** der Kühlkreislauf (11) einen Verdichterbypass (40) aufweist, der in einer Strömungsrichtung des Kältemittels nachfolgend dem Wärmeübertrager (12) und vor dem Niederdruckverdichter (13) sowie nachfolgend dem Niederdruckverdichter und vor dem Hochdruckverdichter (14) an eine Zwischendruckseite (19) des Kühlkreislaufs angeschlossen ist, wobei mittels der Ventileinrichtung (17) Kältemittel zu dem Niederdruckverdichter oder über den Verdichterbypass zu dem Hochdruckverdichter geleitet wird.

4. Verfahren nach einem der vorangehenden Ansprüche,
**dadurch gekennzeichnet,**
**dass** die Steuervorrichtung in Abhängigkeit einer Soll-Temperatur den Hochdruckverdichter (14) betreibt und den Niederdruckverdichter (13) abschaltet und die Ventileinrichtung (17) derart betätigt, dass Kältemittel zu dem Hochdruckverdichter geleitet wird, oder den Hochdruckverdichter und den Niederdruckverdichter betreibt und die Ventileinrichtung derart betätigt, dass Kältemittel zu dem Niederdruckverdichter geleitet wird.

5. Verfahren nach einem der vorangehenden Ansprüche,
**dadurch gekennzeichnet,**
**dass** in dem Kühlkreislauf (11) ein Niederdruckbypass (32) mit zumindest einem Niederdruckventil (33) ausgebildet ist, wobei der Niederdruckbypass in Strömungsrichtung nach dem Gaskühler (15) und vor dem Expansionsventil (16) an eine Mitteldruckseite (21) des Kühlkreislaufs sowie nach der Ventileinrichtung (17) und vor dem Niederdruckverdichter (13) an eine Niederdruckseite (18) des Kühlkreislaufs angeschlossen ist, wobei eine Sauggastemperatur und/oder ein Sauggasdruck des Kältemittels auf der Niederdruckseite des Kühlkreislaufs vor dem Niederdruckverdichter derart geregelt wird, dass über das Niederdruckventil Kältemittel in die Niederdruckseite dosiert wird.

6. Verfahren nach einem der vorangehenden Ansprüche,
**dadurch gekennzeichnet,**
**dass** in dem Kühlkreislauf (11) ein Regelbypass (36) mit zumindest einem Regelventil (37) ausgebildet ist, wobei der Regelbypass in Strömungsrichtung nach dem Niederdruckverdichter (13) und vor dem Hochdruckverdichter (14) an eine Zwischendruckseite (19) des Kühlkreislaufs sowie vor dem Niederdruckverdichter und nach der Ventileinrichtung (17) an eine Niederdruckseite (18) des Kühlkreislaufs angeschlossen ist, wobei über das Regelventil Kältemittel in die Niederdruckseite dosiert wird, wobei eine Sauggastemperatur und/oder ein Sauggasdruck des Kältemittels auf der Niederdruckseite des Kühlkreislaufs vor dem Niederdruckverdichter geregelt wird, und/oder eine Druckdifferenz zwischen der Zwischendruckseite und der Niederdruckseite des Kühlkreislaufs ausgeglichen wird.

7. Verfahren nach einem der vorangehenden Ansprüche,
**dadurch gekennzeichnet,**
**dass** der Kühlkreislauf (11) einen Zwischendruckdruckbypass (30) aufweist, der in der Strömungsrichtung nachfolgend dem Gaskühler (15) und vor dem Expansionsventil (16) an einer Mitteldruckseite (21) des Kühlkreislaufs sowie vor dem Hochdruckverdichter (14) und nachfolgend dem Niederdruckverdichter (13) an eine Zwischendruckseite (19) des Kühlkreislaufs angeschlossen ist, wobei mittels eines Zwischendruckventils (31) Kältemittel von der Mitteldruckdruckseite in die Zwischendruckseite dosiert wird.

8. Verfahren nach einem der vorangehenden Ansprüche,
**dadurch gekennzeichnet,**
**dass** der Kühlkreislauf (11) ein Hochdruckventil (23) und eine Speichereinrichtung (24) aufweist, die an einer Hochdruckseite (20) des Kühlkreislaufs in der Strömungsrichtung nachfolgend dem Gaskühler (15) und vor dem Expansionsventil (16) angeschlossen sind, wobei über das Hochdruckventil Kältemittel in die Speichereinrichtung dosiert wird.

9. Verfahren nach Anspruch 8,
**dadurch gekennzeichnet,**
**dass** der Kühlkreislauf (11) einen internen Wärmeübertrager (22) aufweist, der an der Hochdruckseite (20) des Kühlkreislaufs in der Strömungsrichtung nachfolgend dem Gaskühler (15) und vor dem Expansionsventil (16) angeschlossen ist, wobei der interne Wärmeübertrager mit einem Flashgas-Bypass (27) des Kühlkreislaufs gekoppelt ist, wobei der Flashgas-Bypass in der Strömungsrichtung nachfolgend dem internen Wärmeübertrager und vor dem Expansionsventil an der Speichereinrichtung (24) sowie vor dem Hochdruckverdichter (14) und nachfolgend dem Niederdruckverdichter (13) an eine Zwischendruckseite (19) des Kühlkreislaufs angeschlossen ist, wobei mittels eines Flashgasventils (28) gasförmiges Kältemittel von der Speichereinrichtung über den internen Wärmeübertrager in die Zwischendruckseite dosiert wird.

10. Verfahren nach einem der vorangehenden Ansprüche,
**dadurch gekennzeichnet,**
**dass** in dem Kühlkreislauf (11) ein weiterer Bypass (34) mit zumindest einem weiteren Ventil (35) ausgebildet ist, wobei der weitere Bypass in Strömungsrichtung nach dem Gaskühler (15) und vor dem Expansionsventil (16) an eine Mitteldruckseite (21) des Kühlkreislaufs sowie nach dem Wärmeübertrager (12) und vor der Ventileinrichtung (17) an eine Niederdruckseite (18) des Kühlkreislaufs angeschlossen ist, wobei eine Sauggastemperatur und/oder ein Sauggasdruck des Kältemittels auf der Niederdruckseite des Kühlkreislaufs vor der Ventileinrichtung derart geregelt wird, dass über das weitere Ventil Kältemittel in die Niederdruckseite dosiert wird.

11. Verfahren nach einem der vorangehenden Ansprüche,
**dadurch gekennzeichnet,**
**dass** reines Kohlenstoffdioxid (CO₂) als das Kältemittel verwendet wird.

12. Prüfkammer, insbesondere Klimakammer, zur Konditionierung von Luft, umfassend einen gegenüber einer Umgebung verschließbaren und temperaturgedämmten Prüfraum zur Aufnahme von Prüfgut, und eine Temperiervorrichtung zur Temperierung des Prüfraums, wobei mittels der Temperiervorrichtung eine Temperatur in einem Temperaturbereich von -40 °C bis +180 °C innerhalb des Prüfraums ausbildbar ist, wobei die Temperiervorrichtung eine Kühleinrichtung (10) mit einem Kühlkreislauf (11) mit Kohlenstoffdioxid als einem Kältemittel, einem Wärmeübertrager (12) in dem Prüfraum, einem Niederdruckverdichter (13) und einem in einer Strömungsrichtung des Kältemittels dem Niederdruckverdichter nachfolgenden Hochdruckverdichter (14), einem Gaskühler (15) und einem Expansionsventil (16) aufweist, wobei die Prüfkammer eine Steuervorrichtung zur Steuerung und/oder Regelung der Temperatur in dem Prüfraum aufweist,
**dadurch gekennzeichnet,**
**dass** der Kühlkreislauf eine Ventileinrichtung (17) aufweist, mittels der Kältemittel zu dem Niederdruckverdichter oder zu dem Hochdruckverdichter leitbar ist.

13. Prüfkammer nach Anspruch 12,
**dadurch gekennzeichnet,**
**dass** die Ventileinrichtung (17) durch ein 3-Wege-Ventil (38) ausgebildet ist.

14. Prüfkammer nach einem der Ansprüche 12 oder 13,
**dadurch gekennzeichnet,**
**dass** der Wärmeübertrager (12) mit alleine einem Übertragerkörper ausgebildet ist, wobei alleine eine Leitung des Kühlkreislaufs (11) durch den Übertragerkörper verläuft.

15. Prüfkammer nach einem der Ansprüche 12 bis 14,
**dadurch gekennzeichnet,**
**dass** die Temperiervorrichtung eine Heizeinrichtung mit einer Heizung und einen Heiz-Wärmeübertrager in dem Prüfraum aufweist.
